Europäisches Patentamt

(19) European Patent Office

Office européen des brevets

(11) Veröffentlichungsnummer: **0 146 585**
**B1**

(12) **EUROPÄISCHE PATENTSCHRIFT**

(45) Veröffentlichungstag der Patentschrift:
04.02.87

(51) Int. Cl.⁴: **H 01 F 17/00, H 01 F 27/28**

(21) Anmeldenummer: **84902195.1**

(22) Anmeldetag: **26.05.84**

(86) Internationale Anmeldenummer:
**PCT/DE 84/00118**

(87) Internationale Veröffentlichungsnummer:
**WO 85/00072 (03.01.85 Gazette 85/01)**

(54) INDUKTIVES ELEMENT, INSBESONDERE ÜBERTRAGER.

(30) Priorität: **18.06.83 DE 3322004**

(43) Veröffentlichungstag der Anmeldung:
**03.07.85 Patentblatt 85/27**

(45) Bekanntmachung des Hinweises auf die Patenterteilung:
**04.02.87 Patentblatt 87/6**

(84) Benannte Vertragsstaaten:
**AT CH DE FR GB LI NL SE**

(56) Entgegenhaltungen:
**DE-A-2 054 457**
**DE-A-2 927 364**

(73) Patentinhaber: **ROBERT BOSCH GMBH, Robert- Bosch- Platz 1, D-7016 Gerlingen- Schillerhöhe (DE)**

(72) Erfinder: **BAUM, Helmut, Rembrandtstr. 30, D-7000 Stuttgart 80 (DE)**
Erfinder: **PFIZENMAIER, Heinz, Liststr. 6, D-7250 Leonberg (DE)**
Erfinder: **SCHMIDT, Ewald, Bachstr. 10, D-7140 Ludwigsburg (DE)**
Erfinder: **STRAUSS, Franz, Am Schattwald 8, D-7000 Stuttgart 80 (DE)**

EP 0 146 585 B1

LIBER, STOCKHOLM 1987

## Beschreibung

### Stand der Technik

Die Erfindung geht aus von einem induktiven Element nach der Gattung des unabhängigen Patenaspruches 1. Aus der DT-A- 29 27 364 ist bereits ein induktives Element bekannt, bei welchen der isolierträger aus einen in sich starren Material, beispielsweise aus Glas oder Keramik, besteht. Dieser Träger ist mit flächenhaften Spiralspulen in beliebiger Konfiguration, z.B. kreis-, oval- oder rechteckförmig, in Form von Leiterbahnen bestückt. Die Leiterbahnen können dabei direkt auf dem Träger aufgebracht sein oder sie können sich auf einer dünnen flexiblen Folie befinden, die mit dem Träger verklebt wird. Zum Einsetzen des Ferritkerns in den Träger ist dieser mit vom Rand des Träger ausgehenden Einschnitten oder Schlitzen versehen, die im Abstand des Kernlochdurchmessers voneinander angeordnet sind und deren Breite der Breite der zur Aufnahme des Ferritkerns dienenden Aussparungen entspricht. Diese relativ breiten Schlitze werden durch Drähte oder Stege überbrückt, welche die im Bereich der Schlitze unterbrochenen Leiterbahnen der Spulen miteinander verbinden. Diese Einrichtung hat den Nachteil, daß die in die Aussparungen eingesetzten Ferritkerne während des Transports von der Bestückungsstation zu der Löt- bzw. Klebestation bei unachtsamer Handhabung der Platinen herausfallen können, sofern sie nicht zuvor besonders gesichert wurden. Ein solches Herausfallen kann zwar durch vorheriges Aufbringen der die Leiterbahnen tragenden Klebefolie verhindert werden, jedoch ist die Verwendung einer solchen Folie mit zusätzlichen Kosten verbunden.

Durch die DE-A- 20 54 457 ist ferner ein Hochfrequenzgenerator bzw. eine Hochfrequenzdrossel bekannt geworden, bei welcher zwei Wicklungen als eckige Spiralen in gedruckten Leiterbahnen nebeneinander auf einer Platine oder Folie angebracht sind. Der freie Raum im Innern jeder Spirale ist mit zwei Schlitzen versehen, die parallel zu den benachbarten Leiterbahnabschnitten verlaufen. Zwischen diesen beiden Schlitzen befindet sich ein Querschlitz derart, daß eine herausbiegbare Zunge entsteht, unter die ein nach Art einer Lochscheibe ausgebildeter Ringkern schiebbar ist. Die Querschnittsfläche des Kerns muß dabei wesentlich kleiner sein als der freie Raum im Innern der Spiralen. Außerdem liegt die Ferritschicht an den Windungen der Spiralen tangential an, so das daß die Scheibe nicht durchdringende magnetische Feld erhebliche Anteile aufweist. Dadurch müssen dickere Ferritschichten verwendet werden, um ausreichende Induktivitätserhöhungen zu bekommen. Dies gilt hauptsächlich bei entsprechend hohen Frequenzen, bei denen Ferrite mit entsprechend höherer Anfangspermeabilität schon eine kleinere Permeabilität aufweisen, wie Ferrite mit kleinerer Anfangspermeabilität.

### Vorteile der Erfindung

Das erfindungsgemäße induktive Element mit den kennzeichnenden Merkmalen des Hauptanspruchs hat demgegenüber den Vorteil einer kostengünstigen Herstellung des Isolierträgers verbunden mit einer einfachen Montage des Ferritkerns. Besonders hervorzuheben ist, daß der Kern nach seiner Einführung in die Aussparungen des Isolierträgers unverlierbar mit diesem verbunden ist, ohne daß es besonderer, zusätzlicher Maßnahmen und Vorkehrungen zur Lagesicherung des Kerns in den Aussparungen bedarf. Ein Herausfallen der Kerne beim Transport von der Bestückungsstation zu einer weiteren Station, beispielsweise einer Lötstation, ist somit ausgeschlossen. Durch die Anordnung des Ferritkerns in Aussparungen des Isolierträgers wird der durch alle Leiterbahnen erzeugte Fluß hauptsächlich durch das Kernmaterial geleitet, so daß ein wesentlich höherer Flußanteil das Kernmaterial durchsetzt als es bei der bekannten Anordnung nach der DE-A- 20 54 457 der Fall ist. Bei gleichen Kernquerschnittsflächen ergibt sich somit bei der vorgeschlagenen Bauart ein erheblich geringerer Streufluß und durch die kürzeren Leitungen ein kleinerer Wicklungswiderstand und eine geringere Wicklungskapazität. Dadurch lassen sich Spulen bzw. Übertrager mit besseren Werten, insbesondere höheren Grenzfrequenzen, realisieren.

Durch die in den abhängigen Ansprüchen aufgeführten Maßnahmen sind vorteilhafte Weiterbildungen und Verbesserungen des im Hauptanspruch angegebenen induktiven Elements möglich. Besonders vorteilhaft im Hinblick auf ein leichtes Einführen des Ferritkerns erweist sich ein solcher Verlauf zweier benachbarter Einführungsschlitze, daß die Breite des durch die Schlitze begrenzten Abschnitts der Zunge zum Rande des Isolierträgers hin abnimmt. Damit sich der Isolierträger nicht verwirft, können die Einführungsschlitze weiterhin mit sich nicht berührenden Schnittflächen ausgebildet sein.

### Zeichnung

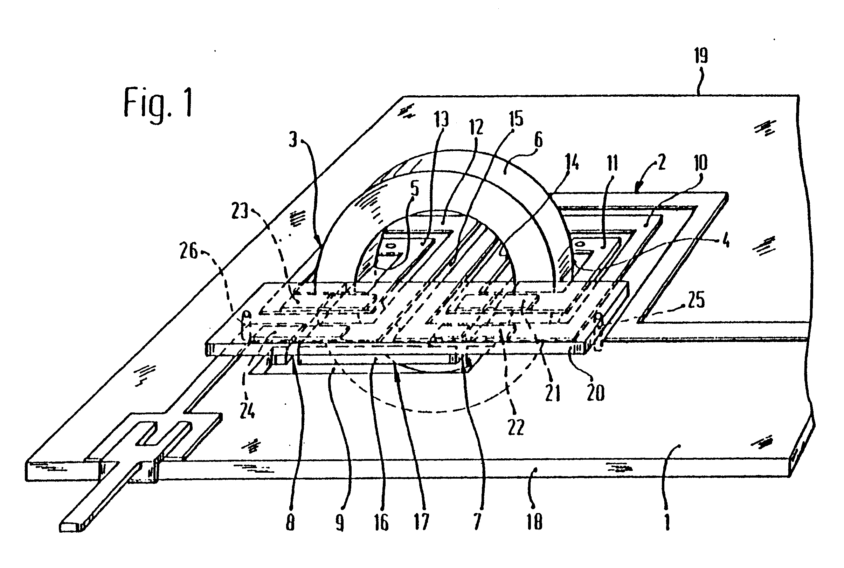

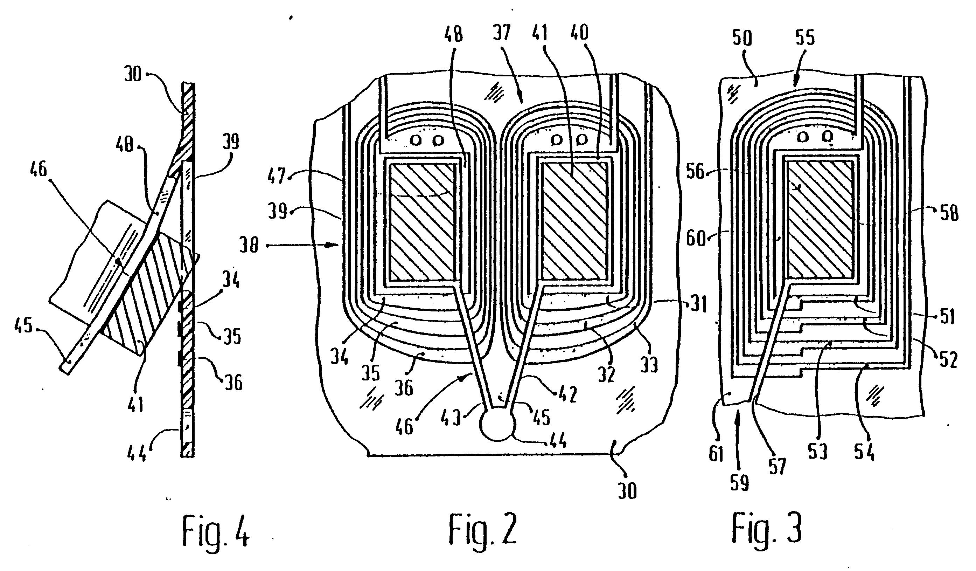

Mehrere Ausführungsbeispiele der Erfindung sind in der Zeichnung dargestellt und in der nachfolgenden Beschreibung näher erläutert. Es zeigen Figur 1 ein erstes Ausführungsbeispiel in perspektivischer Darstellung, Figur 2 ein zweites Ausführungsbeispiel in Draufsicht, Figur 3 eine Spule mit Leiterbahnen, die eine vom Ausführungsbeispiel nach Figur 2 abweichende Form aufweisen, Figur 4 einen Längsschnitt durch den Isolierträger nach Figur 2 mit teilweise eingeführtem Ferritkern.

**Beschreibung der Ausführungsbeispiele**

Der in Figur 1 dargestellte Hochfrequenzübertrager hat einen Isolierträger 1, der aus einem an sich bekannten elastischen Material besteht das hochisolierend ist und nach einer Verformung selbsttätig in seine Planlage zurückfedert. Auf dem Isolierträger 1 sind flächenhaft nach einem bekannten Verfahren zwei Spiralspulen 2, 3 in Form von Leiterbahnen aufgebracht, die in Figur 1 rechteckförmige Konfiguration haben. Im Innern der Spulen 2, 3 befindet sich je eine rechteckförmige Aussparung 4 bzw. 5 zur Aufnahme eines ringförmigen, geschlossenen Ferritkerns 6. Die Größe der Aussparungen 4, 5 ist an den Querschnitt des Kerns 6 angepaßt. Weiterhin sind im Isolierträger 1 zwei Schlitze 7, 8 ausgebildet, welche von einem Durchbruch 9 des Isolierträgers 1 ausgehend in die Aussparungen 4, 5 münden. Diese Schlitze kreuzen die Leiterbahnen 10, 11 bzw. 12, 13 der beiden Spulen 2, 3, so daß die Bahnen im Bereich der Schlitze voneinander getrennt sind.

Das Kernloch 14 des Ferritkerns 6 wird von einem Steg 15 des Isolierträgers 1 durchgriffen, der zusammen mit dem durch die Schlitze 7, 8 begrenzten Abschnitt 16 eine federnde Zunge 17 bildet, die, wie im Zusammenhang mit dem Ausführungsbeispiel nach Figur 2 noch näher beschrieben wird, zum Einführen des Ferritkerns 6 in die Aussparungen 4, 5 aus der Ebene des Isolierträgers aushebbar ist und nach Loslassen selbsttätig in ihre Planlage zurückfedert. Dadurch wird der Ferritkern nach der Montage unverlierbar in den Aussparungen festgehalten, ohne daß es einer zusätzlichen Transportsicherung gegen Herausfallen bedarf.

Die Schlitze 7, 8 verlaufen parallel zueinander und rechtwinklig zu den Außenkanten 18, 19 des Isolierträgers 1. Die Breite des durch die Schlitze begrenzten Abschnitts 16 der Zunge 17 entspricht dabei der Breite des das Kernloch 14 des Ferritkerns 6 durchsetzenden Stegs 15. Die Schlitze 7, 8 sind spaltförmig mit sich nicht berührenden Schnittflächen ausgebildet. Dadurch wird ein Verwerfen des Isolierträgers verhindert. Der in die Aussparungen eingesetzte Ferritkern kann mit Hilfe von Klebstoff an dem Isolierträger 1 befestigt werden, so daß er sich nicht verdrehen kann.

Wie aus Figur 1 ersichtlich, ist im Bereich des Abschnitts 16 der Zunge 17 eine Brücke 20 in Form eines flachen, rechteckigen Teils angeordnet, welche nach erfolgtem Einsetzen des Ferritkerns 6 in die Aussparungen 4, 5 des Isolierträgers 1 die Zunge 17 mit den anderen Teilen des Isolierträgers 1 verbindet. Diese Brücke kann aus einem Stoff mit geringer Flexibilität bestehen, wodurch insbesondere größere Schaltungen mit mehreren induktiven Bauelementen eine größere mechanische Festigkeit erhalten.

Im Ausführungsbeispiel dient als Brücke 20 ein zusätzlicher Isolierträger, der im Bereich der Schlitze 7, 8 mit den dort fehlenden Leiterbahnstücken 21, 22, 23, 24 belegt ist. Diese Leiterbahnstücke sind mit den Leiterbahnen 10 bzw. 11 bzw. 12 bzw. 13 leitend geklebt oder gelötet. Durch diese Maßnahme wird die Zunge 17 mit den angrenzenden Teilen des Isolierträgers 1 fest verbunden und zugleich eine leitende Verbindung zwischen den Leiterbahnen im Bereich der Schlitze 7, 8 hergestellt. Für Brücken mit dieser Doppelfunktion eignet sich neben festen Materialien, z.B. Glas oder Keramik, hochflexible, dünne Isolierstoffe, die insbesondere dann eingesetzt werden, wenn der Isolierträger 1 an sich ausreichende Eigenstabilität aufweist.

Auf der Oberseite der Brücke 20 können zusätzlich noch weitere, nicht dargestellte Leiterstrukturen und/oder Bauelemente angeordnet sein, was die Packungsdichte auf der Fläche des Isolierträgers erhöht. Dem gleichen Zweck dient auch die Maßnahme, die Einführungschlitze 7, 8 für den Ferritkern 6 nicht bis zur Außenkante des Isolierträgers 1 zu verlängern, sondern diese von dem innerhalb des Isolierträgers 1 gelegenen Durchbruch 9 ausgehen zu lassen. Die dadurch eingesparte Fläche kann gleichfalls zum Anbringen zusätzlicher Leiterstrukturen und/oder Bauelemente ausgenutzt werden. Die Brücke 20 und der Isolierträger 1 können ferner mit Bohrungen bzw. Löchern 25, 26 versehen sein, die von Stiften durchgriffen werden, um eine genaue Positionierung der Brücke auf dem Isolierträger während des Löt- bzw. Klebevorgangs zu gewährleisten. Die Löcher können Durchkontaktierungen aufweisen, um eine leitende Verbindung von Leiterstrukturen des Isolierträgers und der Brücke herzustellen.

Beim Ausführungsbeispiel nach Figur 2 sind auf einem Isolierträger 30 wiederum zwei aus Leiterbahnen 31, 32, 33 bzw. 34, 35, 36 bestehende Spulen 37 bzw. 38 angebracht, die jedoch neben geraden auch kreisbogenförmige Zonen haben. Der Isolierträger 30 enthält zwei Aussparungen 39, 40 für einen geschlossenen Ferritkern 41. In die Aussparungen mündet je ein im Isolierträger 30 ausgebildeter Schlitz 42 bzw. 43, der von einem kreisförmigen Durchbruch 44 des Isolierträgers ausgeht. Im Gegensatz zu Figur 1 sind die Schlitze 42, 43 jedoch nicht parallel zueinander angeordnet, sondern haben einen solchen Verlauf, daß die Breite des durch die Schlitze begrenzten Abschnitts 45 der Zunge 46 zum Rande des Isolierträgers 30 abnimmt. Diese Formgebung der Zunge erleichtert die Einführung des Ferritkerns, weil der Zungenanfang wesentlich schmäler ist als der Durchmesser des Kernlochs 47. Der das Kernloch durchsetzende Steg der Zunge 46 ist mit 48 bezeichnet.

Zum Einführen des Ferritkerns 41 in die Aussparungen 39, 40 des Isolierträgers 30 wird die Zunge 46 mittels eines Fingers oder geeigneten Werkzeugs soweit aus der Ebene des Isolierträgers ausgehoben, daß der Kernunter den Abschnitt 45 der Zunge 46 gesteckt werden kann, wobei die Zunge das Kernloch 47 durchgreift (Figur 4). Anschließend wird der Kern zwischen Träger und Zunge soweit verschoben, bis er den Steg 48 erreicht und in die Aussparungen 39, 40 des Isolierträgers 30 einrastet. Bei diesem Vorgang geben sowohl die Zunge 46 als auch das Material des Isolierträgers in bestimmten Grenzen federnd nach. Nachdem der Kern in die Aussparungen eingerastet ist, kehrt die Zunge 46 unter Wirkung der ihr innewohnenden Elastizität wieder in ihre Planlage zurück und hält den Kern 41 unverlierbar im Isolierträgers 30 fest. Beim Ausführungsbeispiel nach Figur 1 wird in gleicher Weise vorgegangen, wobei der Kern 6 zunächst in den Durchbruch 9 des Isolierträgers 1 eingesetzt und in diesem Durchbruch gegenüber der Zunge 17 zentriert wird. Die Breite des Durchbruchs 9 entspricht dabei mindestens der Dicke des Ferritkerns 6 in axialer Richtung.

Nach der Montage des Ferritkerns kann der Isolierträger eine Löt- bzw. Klebestation durchlaufen, in der die Brücke 20 angebracht wird, derart, daß deren Leiterbahnstücke 21 bis 24 eine leitende Verbindung zwischen den durch die Schlitze getrennten Leiterbahnen herstellen.

Um Toleranzen hinsichtlich Positionierung und Dimensionsstabilitäten von Isolierträger und Brücke besser auffangen zu können und genügend große Lötflächen zu erhalten sind bei den Ausführungsbeispielen nach den Figuren 2 und 3 die Leiterbahnen im Bereich der Einführungsschlitze auf größere Breiten und größere Leiterbahnabstände aufgefächert. Beim Ausführungsbeispiel nach Figur 2 ist dabei die Anordnung so getroffen, daß die Breite der Leiterbahnen 31 bis 36 und deren Abstände voneinander in Richtung der Schlitze 42, 43 von beiden Seiten her kontinuierlich zunimmt, so daß großdimensionierte Lötstellen mit genügendem Abstand voneinander vorhanden sind. Die kontinuierliche Auffächerung erbringt einen relativ kleinen Leitungswiderstand und gute Hochfrequenz-Reflexionseigenschaften.

In Figur 3 sind die auf einem Isolierträger 50 aufgebrachten Leiterbahnen 51, 52, 53, 54 einer Spule 55 mit geschlossenem Ferritkern 56 im Bereich eines die Leiterbahnen kreuzenden Einführungsschlitzes 57 für den Kern so ausgestaltet, daß ihr Abstand und ihre Breite im Bereich des Schlitzes 57 sprunghaft zunimmt. Diese Anordnung erbringt hinsichtlich der Herstellung einer leitenden Verbindung der Leiterbahnen mit den Leiterbahnstücken einer nicht dargestellten Brücke die gleichen Vorteile wie die Anordnung nach Figur 3, wobei die geraden, rechtwinkelig zueinander verlaufenden Leiterbahnen bei der Layout-Entwicklung zeitliche Vorteile erbringen. Die Aussparung für den Ferritkern 56 ist in Figur 3 mit 58 bezeichnet. Die Zunge trägt die Bezugszahl 59, der Zungensteg die Bezugszahl 60 und der vordere Zungenabschnitt die Bezugszahl 61.

Zur Verbindung von Isolierträger und Brücke kann eine auf das eine Teil oder auf beide Teile galvanisch aufgebrachte Zinn-Blei-Schicht dienen. Dadurch hat man bereits vor der Verlötung eine ebene, ganzflächige Leiterberührung, die eine wesentlich größere Lötsicherheit gegenüber der gleichfalls anwendbaren Tauchverzinnung gewährleistet. Die Verlötung kann vorteilhaft in einem Durchlaufofen unter mechanischem Druck erfolgen.

Die vorgeschlagene Anordnung ist nicht nur zur unverlierbaren Halterung von geschlossenen Einloch-Ferritkernen, sondern auch von Mehrlochkernen geeignet. Hierbei wird jedes Kernloch von einer federnden Zunge durchgriffen, die gleiche oder ähnliche Form haben kann wie die in den Figuren 1 und 2 gezeigten Zungen.

**Patentansprüche**

1 - Induktives Element, insbesondere Übertrager, mit geschlossenem Ferritkern (6) und mit mindestens einer auf einem Isolierträger (1, 30, 50) in Form von gedruckten Leiterbahnen aufgebrachten Spule (2, 3; bzw 37, 38; 55), wobei der Isolierträger (1) an den Querschnitt des Ferritkerns (6) angepaßte Aussparungen (4, 5) zur Aufnahme des Ferritkerns (6) sowie in die Aussparungen (4, 5) mündende, die Leiterbahnen (10-13) kreuzende Schlitze (7, 8) zum Einführen des Ferritkerns (6) in die Aussparungen (4, 5) aufweist, dadurch gekennzeichnet, daß der Isolierträger (1 bzw. 30 bzw. 50) aus einem elastischen Material besteht und der das Kernloch (14 bzw. 47) durchsetzende Steg (15 bzw. 48 bzw. 60) zusammen mit dem durch zwei benachbarte Schlitze (7, 8 bzw. 42, 43 bzw. 57) begrenzten Abschnitt (16 bzw. 45 bzw. 61) des Isolierträgers eine federnde Zunge (17 bzw. 46 bzw. 59) bildet, die zum Einführen des Ferritkerns in die Aussparungen (4, 5 bzw. 39, 40 bzw. 58) aus der Ebene des Isolierträgers aushebbar ist.

2. Induktives Element nach Anspruch 1, dadurch gekennzeichnet, daß die Schlitze (7, 8) parallel zueinander und rechtwinklig zu einer Außenkante (18, 19) des Isolierträgers (1) verlaufen, und daß die Breite des durch zwei benachbarte Schlitze begrenzten Abschnitts (16) der Zunge (17) der Breite des das Kernloch (14) durchsetzenden Stegs (15) entspricht.

3. Induktives Element nach Anspruch 1, gekennzeichnet durch einen solchen Verlauf zweier benachbarter Einführungsschlitze (42, 43), daß die Breite des durch die Schlitze begrenzten Abschnitts (45) der Zunge (46) zum Rande des Isolierträgers (30) hin abnimmt.

4. Induktives Element nach Anspruch 1, dadurch gekennzeichnet, daß die Schlitze (7, 8 bzw. 42, 43 bzw. 57) spaltförmig mit sich nicht berührenden Schnittflächen ausgebildet sind.

5. Induktives Element nach Anspruch 1, dadurch gekennzeichnet, daß die Zunge (17 bzw. 46) innerhalb der Fläche des Isolierträgers (1 bzw. 30) in einem im Träger ausgebildeten Durchbruch (9 bzw. 44) endet.

6. Induktives Element nach Anspruch 1, dadurch gekennzeichnet, daß im Bereich der Schlitze (7, 8 bzw. 42, 43 bzw. 57) eine Brücke (20) angeordnet ist, mittels welcher nach erfolgtem Einsetzen des Ferritkerns (6 bzw. 41 bzw. 56) in die Aussparungen (4, 5 bzw. 39, 40 bzw. 58) des Isolierträgers (1 bzw. 30 bzw. 50) die Zunge (17 bzw. 46 bzw. 59) mit den angrenzenden Teilen des Isolierträgers verbindbar ist.

7. Induktives Element nach Anspruch 6, dadurch gekennzeichnet, daß als Brücke (20) ein zusätzlicher Isolierträger dient, der im Bereich der Schlitze (7, 8 bzw. 42, 43 bzw. 57) mit den fehlenden Leiterbahnstücken (21 bis 24) belegt ist, und daß die Leiterbahnen (10 bis 13 bzw. 31 bis 36 bzw. 51 bis 54) der Spule (2, 3 bzw. 37, 38 bzw. 55) mit den Leiterbahnstücken des Trägers leitend geklebt oder gelötet sind.

8. Induktives Element nach Anspruch 7, dadurch gekennzeichnet, daß die Leiterbahnen (31 bis 36 bzw. 51 bis 54) der Spule (37, 38 bzw. 55) im Bereich der Schlitze (42, 43 bzw. 57) auf größere Breiten und/oder größere Leiterbahnabstände aufgefächert sind.

9. Induktives Element nach Anspruch 8, dadurch gekennzeichnet, daß die Leiterbahnbreite und/oder der Leiterbahnabstand zu den Schlitzen (42, 43) hin kontinuierlich zunimmt.

10. Induktives Element nach Anspruch 8, dadurch gekennzeichnet, daß die Leiterbahnbreite und/oder der Leiterbahnabstand im Bereich des die Leiterbahnen (51 bis 54) kreuzenden Schlitzes (57) sprunghaft zunimmt.

**Claims**

1. Inductive element, in particular transformer, with closed ferrite core (6) and with at least one coil (2, 3; or 37, 38; 55) deposited on an insulating carrier (1, 30, 50) in the form of printed conductor tracks, the insulating carrier (1) having cutouts (4,5) matched to the cross-section of the ferrite core (6) for receiving the ferrite core (6) and also slots (7, 8) debouching into the cutouts (4, 5) and crossing the conductor tracks (10-13) for introducing the ferrite core (6) into the cutouts (4, 5) characterized in that the insulating carrier (1 or 30 or 50) consists of an elastic material and that the bridge (15 or 48 or 60) which closes the core hole (14 or 47) forms, together with the section (16 or 45 or 61) of the insulating carrier bounded by two adjacent slots (7, 8 or 42, 43 or 57), a spring tongue (17 or 46 or 59) which can be lifted out of the plane of the insulating carrier to introduce the ferrite core into the cutouts (4, 5 or 39, 40 or 58).

2. Inductive element according to claim 1, characterized in that the slots (7, 8) run parallel to each other and at right angles to an outside edge (18,19) of the insulating carrier (1), and that the width of the section (16) of the tongue (17) banded by two adjacent slots corresponds to the width of the bridge (15) crossing the core hole (14).

3. Inductive element according to claim 1, characterized by two adjacent insertion slots (42, 43) running in a manner such that the width of the section (45) of the tonge (46) banded by the slots decreases towards the edge of the insulating carrier (30).

4. Inductive element according to claim 1, characterized in that the slots (7, 8 or 42, 43 or 57) are constructed in the form of gaps with cut faces which do not touch each other.

5. Inductive element according to claim 1, characterized in that the tongue (17 or 46) terminates in a perforation (9 or 44) formed in the carrier inside the plane of the insulating carrier (1 or 30).

6. Inductive element according to claim 1, characterized in that, in the region of the slots (7, 8 or 42, 43 or 57), there is disposed a bridge (20) by means of which, after insertion of the ferrite core (6 or 41 or 56) into the cut-outs (4, 5 or 39, 40 or 58) of the insulating carrier (1 or 30 or 50) is completed, the tongue (17 or 46 or 59) can be connected to the adjacent parts of the insulating carrier.

7. Inductive element according to claim 6, characterized in that an additional insulating carrier, which is covered with the missing pieces of conductor track (21-24) in the region of the slots (7, 8 or 42, 43 or 57) serves as bridge (20) and that the conductor tracks (10-13 or 31-36 or 51-54) of the coil (2, 3 or 37, 38 or 55) are bonded or soldered to the pieces of conductor track of the carrier.

8. Inductive element according to claim 7, characterized in that the conductor tracks (31-36 or 51-54) of the coil (37, 38 or 55) are fanned out to larger widths and/or larger conductor track spacings in the region of the slots (42, 43 or 57).

9. Inductive element according to claim 8, characterized in that the conductor track width and/or the conductor track spacing increases continuously towards the slots (42, 43).

10. Inductive element according to claim 8, characterized in that the conductor track width and/or the conductor track spacing increases abruptly in the region of the slot (57) crossing the conductor tracks (51-54).

**Revendications**

1. Elément inductif, en particulier transformateur, comportant un noyau de ferrite fermé (6) et au moins une bobine (2, 3; ou 37, 38;

55) rapportée sur un support isolant (9, 30, 50) sous forme de rubans conducteurs imprimés, étant précisé que le support isolant (1) présente des évidements (4, 5) adaptés à la section du noyau de ferrite (6) pour recevoir le noyau de ferrite (6), ainsi que des entailles (7, 8) qui débouchent dans les évidements (4, 5) et croisent les rubans conducteurs (10-13), pour permettre l'introduction du noyau de ferrite (6) dans les évidements (4, 5), caractérisé en ce que le support isolant (1 ou 30 ou 50) est constitué d'un matériau élastique; et en ce que la barrette (15 ou 48 ou 60) qui passe à travers le trou du noyau (14 ou 47) forme, avec le tronçon (16 ou 45 ou 61) du support isolant limité par deux entailles voisines (7, 8 ou 42, 43 ou 57) une languette élastique (17 ou 46 ou 59) que l'on peut soulever hors du plan du support isolant pour introduire le noyau de ferrite dans les évidements (4, 5 ou 39, 40 ou 58).

2. Elément inductif selon la revendication 1, caractérisé en ce que les entailles (7, 8) courent parallèlement l'une à l'autre et perpendiculairement à un bord extérieur (18, 19) du support isolant (1); et en ce que la largeur du tronçon (16) de la languette (17) limité par deux entailles voisines correspond à la largeur de la barrette (15) qui passe à travers le trou du noyau (14).

3. Elément inductif selon la revendication 1, caractérisé par une allure des deux entailles d'introduction voisines (42, 43) telle que la largeur du tronçon (45) de la languette (46) limité par les entailles va en diminuant en allant vers le bord du support isolant (30).

4. Elément inductif selon la revendication 1, caractérisé en ce que les entailles (7, 8 ou 42, 43 ou 57) ont le forme de fentes avec des surfaces de coupe qui ne se touchent pas.

5. Elément inductif selon la revendication 1, caractérisé en ce que la languette (17 ou 46), se termine à l'intérieur de la surface du support isolant (1 ou 30), dans une découpe traversante (9 ou 44) prévue dans le support.

6. Elément inductif selon la revendication 1, caractérisé en ce que, dans la zone des entailles (7, 8 ou 42, 43 ou 57), est dispose un pont (20) au moyen duquel, une fois effectuée la mise en place du noyau de ferrite (6 ou 41 ou 56) dans les évidements (4, 5 ou 39, 40 ou 58) du support isolant (1 ou 30 ou 50), on peut relier la languette (17, 46 ou 59) aux parties voisines du support isolant.

7. Elément inductif selon la revendication 6, caractérisé en ce que l'on utilise comme pont (20) un support isolant supplémentaire qui, dans la zone des entailles (7, 8 ou 42, 43 ou 57), est garni des morceaux manquants de rubans conducteurs (21 à 24); et en ce que les rubans conducteurs (10 à 13 ou 31 à 36 ou 51 à 54) de la bobine (2, 3 ou 37, 38 ou 55) sont collés ou soudés, avec conduction du courant, aux morceaux de rubans conducteurs du support.

8. Elément inductif selon la revendication 7, caractérisé en ce que les rubans conducteurs (31 à 36 ou 51 à 54) de la bobine (37, 38 ou 55), dans la zone des entailles (42, 43 ou 57), vont en s'ouvrant en éventail pour atteindre des plus grandes largeurs et/ou des plus grandes distances entre rubans conducteurs.

9. Elément inductif selon la revendication 8, caractérisé en ce que la largeur des rubans conducteurs et/ou la distance entre les rubans conducteurs et les entailles (42, 43) va en croissant de façon continue.

10. Elément inductif selon la revendication 8, caractérisé en ce que la largeur des rubans conducteurs et/ou la distance des rubans conducteurs va en croissant par sauts dans la zone de l'entaille (57) qui croise les rubans conducteurs (51 à 54).

Fig. 1

0 146 585

Fig. 3

Fig. 2

Fig. 4